Europäisches Patentamt

**European Patent Office**

Office européen des brevets

(19)

(11) Publication number: **0 165 796**
**A2**

(12)

# EUROPEAN PATENT APPLICATION

(21) Application number: **85304312.3**

(22) Date of filing: **17.06.85**

(51) Int. Cl.⁴: **G 01 R 27/14**

(30) Priority: **21.06.84 GB 8415813**

(43) Date of publication of application:
**27.12.85 Bulletin 85/52**

(84) Designated Contracting States:
**AT BE CH DE FR GB IT LI LU NL SE**

(71) Applicant: **THORN EMI Instruments Limited**
**Avocet House Archcliffe Road**
**Dover Kent, CT17 9EN(GB)**

(72) Inventor: **Hardy, William**
**196, High Street**
**Deal Kent(GB)**

(74) Representative: **Marsh, Robin Geoffrey et al,**
**Thorn EMI Patents Limited The Quadrangle Westmount**
**Centre Uxbridge Road**
**Hayes Middlesex, UB4 0HB(GB)**

(54) An instrument for measuring resistance.

(57) An instrument for measuring internal resistance of a wiring installation includes a switching arrangement (13, 14, 15) to connect a load resistance temporarily across output terminals of the installation. An integration circuit (22) integrates a voltage developed across the output terminals, over respective predetermined intervals of time, in the loaded and unloaded conditions. The integrated values are utilised to evaluate the internal resistance.

FIG.1

: 1 :

## AN INSTRUMENT FOR MEASURING RESISTANCE

This invention relates to an instrument for measuring resistance and in particular though not exclusively, to such an instrument for measuring the internal resistance (source impedence) of an electrical wiring installation.

Instruments of this kind are generally employed to ensure that the installation complies with safety standards by determining whether the installation has a resistance sufficiently low to permit adequate current to flow, so as to enable protective devices, such as a fuse or a circuit breaker, to operate in the event of a live-earth fault.

Such known instruments can be used to check each circuit continuity of each individual three-pin mains supply socket of the installation by inserting a test lead into each socket, in turn, and depressing a push button on the instrument to initiate a test, during which the internal resistance of the installation is measured.

The instrument usually calculates this resistance by measuring a single peak value of the voltage signal when the installation is in a loaded and an unloaded condition respectively, and display the result on a calibrated scale.

However, such instruments employing this type of measurement technique may exhibit relatively high power consumption, thereby necessitating the inclusion of a transformer, which may consequently increase manufacturing costs of the instrument.

Moreover, measurement of a single voltage value may produce erroneous results if it should coincide with a peak in the noise level.

. It is therefore an object of the present invention to provide an instrument for measuring resistance of an electrical wiring installation, which is substantially easier to operate and less expensive to manufacture than instruments of this kind known heretofore.

According to the present invention there is provided an instrument for measuring resistance of an electrical wiring installation including means for temporarily connecting said instrument into the installation, means for introducing a load resistance across the installation, means for integrating, over respective predetermined time intervals, the source voltage when said installation is in a loaded and an unloaded condition, so as to evaluate a voltage value when the installation is in each of said respective conditions, and means for utilising said voltage values to evaluate said resistance of the installation.

The instrument preferably includes an automatic test circuit for initiating a test measurement of the resistance at a predetermined time after the instrument has been connected into the installation, thereby obviating the need for manual     . initiation of the test, such as by depression of a test button.    The use of an automatic facility in this regard . obviates the need to provide the user with instructions as to maximum test rate, etc.

It is also preferable that the instrument incorporates an audible signal which is arranged to sound when the test has been completed, thereby alerting a user of the instrument to the fact that the test is complete and that the result of the test is currently being displayed, preferably on a LCD provided on the instrument.

Integration is preferably implemented over only one of either the positive or negative half cycles of an a.c. waveform generated by the source, as integration over both positive and negative half cycles may cause errors if the circuit of the instrument has a d.c. offset.

The instrument, in accordance with the present invention, is advantageous over known instruments of this kind, in that it consumes relatively little power and thus can be operated directly from a 5V power supply built into the instrument and powered, when appropriately connected, from the a.c. source, thereby obviating the need for a transformer.

The invention will now be further described by way of example only with reference to the accompanying drawings wherein:

Figure 1 shows schematically a front view of an instrument, in accordance with one example of the present invention, and

Figure 2 shows a circuit diagram thereof.

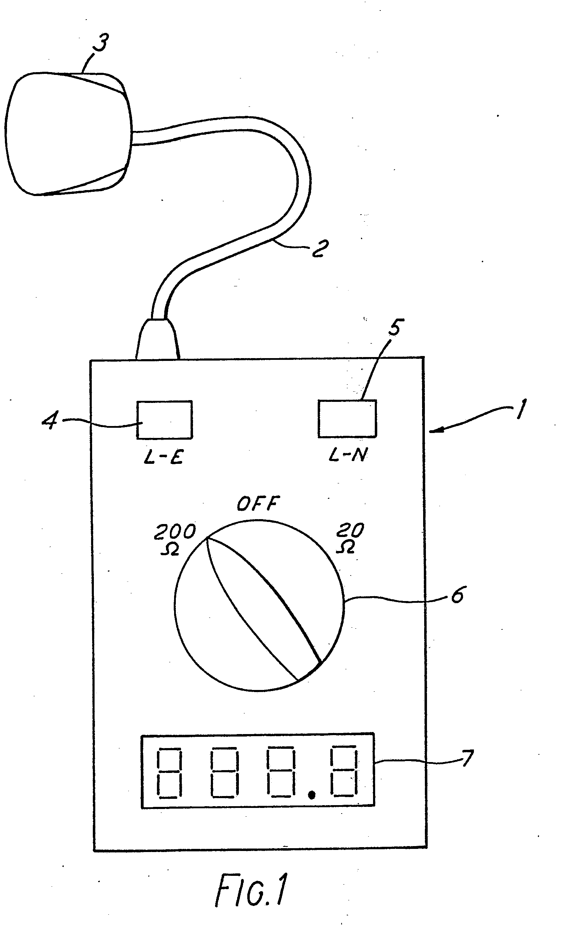

Referring to Figure 1, an instrument shown generally at 1, has a lead 2 which is connected, at one end into a socket (not shown) at the top thereof, the lead 2 having a conventional three-pin plug 3 connected to the other end thereof. To carry out a test to measure the internal resistance of an electrical wiring installation, the plug 3 is simply inserted, in turn, into each three-pin mains supply socket (not shown) of the installation. Any variation in the results of the test from socket to socket outside prescribed limits of tolerance should indicate that the installation contains faulty wiring and/or badly made contacts.

On insertion of the plug 3 into a mains supply socket, neon lights 4 and 5 are illuminated, thereby providing an automatic check that there is earth circuit continuity, ie. that an internal fuse (not shown in Figure 1) of the instrument 1 is intact and that the line connection is correctly wired.

A user-rotatable knob 6 is also provided on the instrument 1, enabling a user of the instrument to choose whether the installation under test should be loaded with a "20$\Omega$" or "200$\Omega$" load resistance during the test. The knob 6 is also provided with an "OFF" position when no load is connected across the installation.

The test is initiated automatically by the instrument 1 at a predetermined time interval, preferably approximately two seconds, after insertion. When the test has been completed, the value of the internal resistance of the installation is displayed on a liquid crystal display 7 and at that time an audible signal, such as a buzzer, is arranged to sound, so as to alert the user to the fact that the test is complete.

To evaluate the internal resistance $R_S$ of the installation, the instrument is arranged to utilise the relevant known and measured parameters to solve the following simple equation:

$$R_S = \frac{R_L \left( V_S - V_L \right)}{V_L}$$

where $R_L$ is the predetermined known load resistance, $V_S$ is the voltage value of the installation in an unloaded condition, and $V_L$ is the voltage value of the installation in a loaded condition. In order to evaluate the value of $R_S$, it is therefore necessary for the instrument to measure the respective values of $(V_S-V_L)$ and $V_L$.

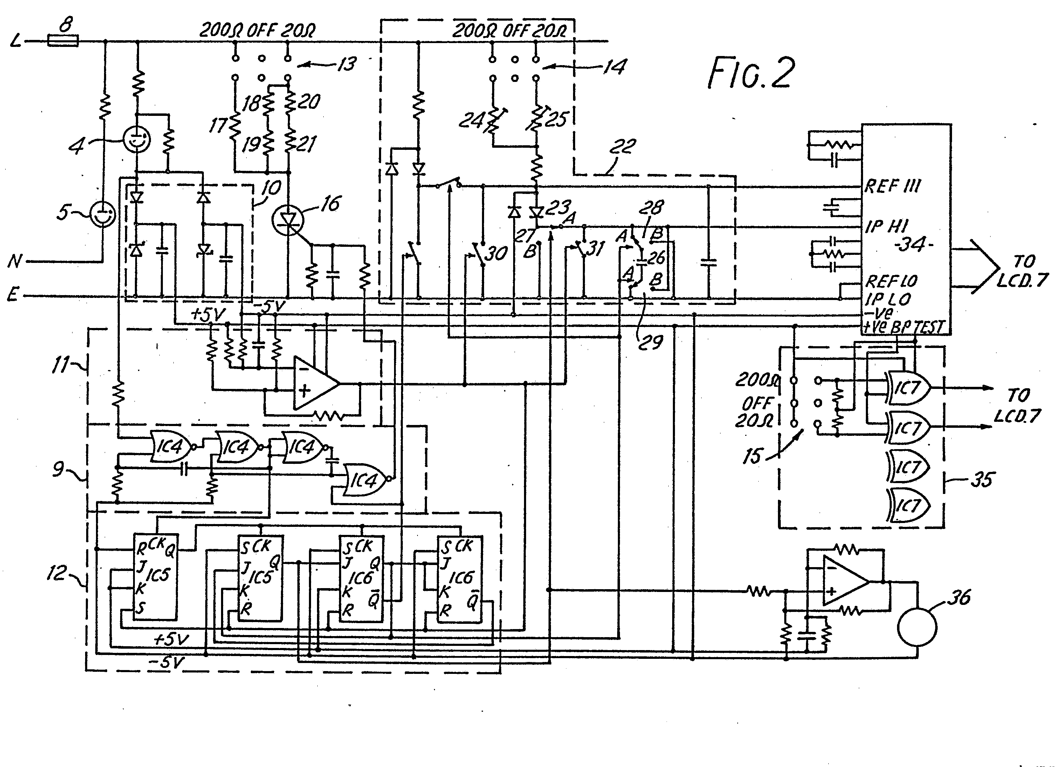

Figure 2 shows a circuit diagram of the instrument 1 connected to the mains power supply, via the installation under test, and the internal fuse of the instrument is shown at 8. When the instrument is connected to the supply, neon lights 5 and 6 are illuminated. An a.c. signal is passed from the line-earth connection "L-E" to a "zero crossing detection" circuit 9 and a rectified signal is passed to an "automatic test" circuit 11, which, together with a "timing" circuit 12, is arranged to initiate a test by opening switches 30 and 31, at a predetermined time interval after connection of the instrument into the installation under test.

Switch contacts 13, 14 and 15 are connected by rotation of the knob 6, in dependence on the value of the load resistance that the user wishes to set on the knob 6 of the instrument.

"Zero crossing detection" circuit 9 and "timing" circuit 12 apply the set load resistance across the installation for a predetermined number of positive half cycles of the source waveform, by permitting thyristor 16 to conduct, so as to connect either resistor 17 or resistors 18 to 21 across the line-earth connection "L-E".

Thus, with the installation in a loaded condition, "integrating" circuit 22 integrates over a predetermined number of positive half cycles of the voltage output signal, which is rectified by diode 23, via either resistor 24 or resistor 25 (in dependence on the set load resistance), and a charging capacitor 26, with switches 27, 28 and 29 in positions A, as shown. The charge stored on capacitor 26 is therefore indicative of the integrated value of the voltage when the installation is in a loaded condition, i.e. $V_L$.

On completion of the predetermined number of positive half cycles in the loaded condition, transistor 16 is made non-conductive and switches 28 and 29 are switched to positions B so as to reverse the polarity of the capacitor 26. The voltage across this capacitor is therefore proportional to - $V_L$. "Integrating" circuit 22 then integrates over a predetermined number of positive half cycles of the voltage signal when the installation is in an unloaded condition. The integration is again implemented by resistor 24 or 25, diode 23 and charging capacitor 26, so that a value $V_S$ of the voltage when the installation is in an unloaded condition is added to the voltage value - $V_L$, which is already applied across capacitor 26. The charge stored on capacitor 26 is therefore indicative of the value $(V_S - V_L)$.

The measured voltage values $(V_S - V_L)$ and $V_L$ are then utilised by A to D converter 34, together with the known load resistance $R_L$, i.e. either 20$\Omega$ or 200$\Omega$, to evaluate the internal resistance $R_S$ of the installation, in accordance with the above equation.

The resistance, in ohms, is then displayed on the LCD 7 and circuit 35 is incorporated to set the decimal point on the display 7, in dependence on the setting of the switch contacts 15.

When the required integration is complete, "timing circuit" 12 switches switch 27 to position B and activates a buzzer 36, at which time resistance is displayed on the LCD 7.

The number of half cycles over which integretion is carried out in the unloaded condition is not critical. However, for safety reasons, the number of half cycles utilised in the loaded condition should be limited to a maximum of three. It is preferable to use two half cycles in the loaded condition, thereby reducing any effect caused by the noise level whilst being safely within the time period allowed.

Only the positive half cycles of the voltage signal are utilised for integration purposes, because utilisation of the negative half cycles too may cause errors, if the circuit arrangement has a d.c. offset.

The instrument consumes relatively little power, so that it can be operated directly from a 5V power supply 10 built into the instrument, thereby obviating the need for a transformer, which may be required in known instruments of this kind.

As an alternative to the lead 2 and the plug 3, a double lead connection may be used, each lead having a probe connected to the free end thereof. The probes may then be used to make connections with the "L-E" and "L-N" lines of, for example, a lighting installation. For such an application, it can be envisaged that the automatic test facility provided by circuit 11 is of great advantage, as it obviates the need for the user of the instrument to depress a push-button as well as holding the two probes to initiate the test.

As an alternative to the rotatable knob 6 to set the load resistance, a slideable switch may of course be employed.

The specific embodiment described above relates to an instrument for measuring the internal resistance of an a.c. electrical wiring installation. A d.c. installation may however be tested by the present instrument by modifying the "timing" circuit 12 to include an oscillator.

## CLAIMS

1. An instrument for measuring an electrical resistance of a wiring installation used to supply an electrical voltage, the instrument comprising switching means (13, 14, 15) to connect temporarily a load resistance across output terminals of the installation and being characterised by provision of means (22) to integrate, over respective predetermined intervals of time, a voltage developed across the output terminals when the installation is in the loaded and in the unloaded conditions thereby to evaluate a voltage value when the installation is in each of said conditions, and means (34) for utilising the voltage values to evaluate said electrical resistance of the wiring installation.

2. An instrument according to Claim 1 including a timing circuit (12) arranged to initiate a said measurement of electrical resistance on expiry of a delay, of preset duration, which commences when the instrument is connected into the installation.

3. An instrument according to Claim 2 wherein said timing circuit (12) is arranged to generate a timing signal to control the switching means (13, 14, 15).

4. An instrument according to Claim 3 including means (36), responsive to a said timing signal, to generate a warning signal, perceptible by a user, to indicate that a measurement of electrical resistance has been completed.

5. An instrument according to Claims 1 to 4 wherein the integration means (22) includes means to effect integration over alternate half cycles only of an a.c. voltage developed across the output terminals.

FIG.1

0165796

FIG.2